(19) Europäisches Patentamt / European Patent Office / Office européen des brevets

(11) **EP 3 432 491 B1**

(12) **EUROPEAN PATENT SPECIFICATION**

(45) Date of publication and mention
of the grant of the patent:
**05.01.2022   Bulletin 2022/01**

(51) Int Cl.:
**H01Q 1/24** *(2006.01)*     **H01Q 1/06** *(2006.01)*
**H01Q 1/28** *(2006.01)*     **H04B 7/06** *(2006.01)*
**H04B 17/12** *(2015.01)*     **H04B 17/00** *(2015.01)*
**G01R 29/10** *(2006.01)*     **H01Q 3/26** *(2006.01)*
**H01Q 21/06** *(2006.01)*     **H01Q 21/28** *(2006.01)*

(21) Application number: **17182571.4**

(22) Date of filing: **21.07.2017**

(54) **WIRELESS COMMUNICATION DEVICE, ANTENNA TEST DEVICE, A TEST SYSTEM AND METHOD FOR TESTING ANTENNA BEAM CHARACTERISTICS**

DRAHTLOSKOMMUNIKATIONSVORRICHTUNG, ANTENNENTESTVORRICHTUNG, TESTSYSTEM UND VERFAHREN ZUM TESTEN VON ANTENNENSTRAHLEIGENSCHAFTEN

DISPOSITIF DE COMMUNICATION SANS FIL, DISPOSITIF DE TEST D'ANTENNE, SYSTÈME DE TEST ET PROCÉDÉ POUR TESTER LES CARACTÉRISTIQUES D'UN FAISCEAU D'ANTENNE

(84) Designated Contracting States:
**AL AT BE BG CY CZ DE DK EE ES FI FR GB GR HR HU IS IT LT LU LV MC MK MT NL NO PL PT RO RS SE SI SK SM TR**

(43) Date of publication of application:
**23.01.2019   Bulletin 2019/04**

(73) Proprietor: **Rohde & Schwarz GmbH & Co. KG**
**81671 München (DE)**

(72) Inventor: **Baeder, Uwe**
**85435 Erding (DE)**

(74) Representative: **Prinz & Partner mbB**
**Patent- und Rechtsanwälte**
**Rundfunkplatz 2**
**80335 München (DE)**

(56) References cited:
• **Rohde And Schwarz: "Antenna Array Testing -Conducted and Over the Air: The Way to 5G White Paper Table of Contents 1MA286_2e Rohde & Schwarz Antenna Array Testing -Conducted and Over the Air: The Way to 5G 2 1 Introduction: What is 5G?", , 20 March 2017 (2017-03-20), XP055429495, Retrieved from the Internet: URL:https://cdn.rohde-schwarz.com/pws/dl_downloads/dl_application/application_notes/1ma286/1MA286_2e_AntArrTest_5G.pdf [retrieved on 2017-11-28]**

• **KATHREIN: "Text proposal: Near Field Measurement Method using Standard 3GPP Interfaces", 3GPP DRAFT; R4-164982, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG4, no. Gothenburg, Sweden; 20160822 - 20160826 10 August 2016 (2016-08-10), XP051142926, Retrieved from the Internet: URL:http://www.3gpp.org/ftp/tsg_ran/WG4_Radio/TSGR4_80/Docs/ [retrieved on 2016-08-10]**

• **ERICSSON: "On Near-Field testing of AAS BS", 3GPP DRAFT; R4-157661, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. TSG RAN, no. Anaheim US; 20151116 - 20151120 16 November 2015 (2015-11-16), XP051010236, Retrieved from the Internet: URL:http://www.3gpp.org/ftp/Meetings_3GPP_SYNC/RAN4/Docs/ [retrieved on 2015-11-16]**

• **Rohde & Schwarz Gmbh & Co Kg: "Antenna Array Testing | Conducted and Over the Air: The Way to 5G | Rohde & Schwarz", , 20 March 2017 (2017-03-20), XP055665484, Retrieved from the Internet: URL:https://www.rohde-schwarz.com/nl/applications/antenna-array-testing-conducted-and-over-the-air-the-way-to-5g-white-paper_230854-353344.html?rusprivacypolicy=0 [retrieved on 2020-02-05]**

## Description

The invention relates to a wireless communication device, an antenna test device for testing antenna beam characteristics of a wireless communication device, a test system as well as a method for testing antenna beam characteristics of a wireless communication device.

Mobile devices such as mobile phones may comprise antenna arrays for exchanging communication link signals with a base station having an antenna array for communication purposes. Accordingly, the base station as well as the mobile devices correspond to wireless communication devices. Generally, the antenna array comprises a set of multiple antenna elements connected to each other. The multiple antennas are interconnected and controlled such that they work together as a single antenna element. The antenna array can be connected to a transmitter and/or a receiver in order to transmit and/or receive electromagnetic signals, in particular radio waves.

Antenna arrays are typically used for beam steering/forming purposes. Beam steering/forming relates to the changing of the direction of the main lobe of a radiation pattern provided by the antenna (array). This can be achieved by switching the individual antenna elements appropriately and/or by changing the relative phases of the radio waves radiated by the individual antenna elements of the antenna array. The individual radio waves radiated of each individual antenna element can be combined and superposed for beam steering/forming purposes such that they interfere constructively to enhance the power radiated in a direction intended whereas they interfere destructively to reduce the power radiated in directions not intended for signal transmission. For receiving purposes, the individual antenna elements are controlled in a similar manner. Beam steering/forming usually relates to the far field of the radiation pattern provided by the antenna array.

The aperture of such an antenna array and the wavelength of the signals determine the beginning of the far field of the radiation pattern radiated by the antenna array which is often located far away from the wireless communication device itself, for instance several meters. The transition of the near field to the far field is typically defined by $T_{farfield} = \frac{2*D^2}{\lambda}$, wherein $D^2$ and $\lambda$ correspond to the aperture of the antenna array and the wavelength of the radio waves, respectively. Hence, the wireless communication device is typically measured in the near field as each individual antenna element of the antenna array is measured by a near field measuring antenna. The far field characteristics of the antenna array, in particular its radiation pattern, cannot be determined due to the fact that only the near field characteristics of the antenna array can be measured.

At present, tests of the antenna array are performed by conventional over-the-air-measurements (OTA measurements).

Kathrein: "Text proposal: Near Field Measurement Method using Standard 3GPP Interfaces", 3GPP DRAFT; R4-164982, 3RD GENERATION PARTNERSHP PROJECT (3GPP), MOBILE COMPETENCE CENTRE; 650, ROUTE DES LUCIOLES; F-06921 SOPHIA-ANTIPOLIS CEDEX; FRANCE, vol. RAN WG4, no. Gothenburg, SwedenM 20160822 - 20160826 discloses a test setup comprising a probe antenna and a reference antenna both emitting signals to an active antenna system. The signals emitted are superimposed for calculating phase information.

Accordingly, there is a need for a possibility to retrieve information regarding the far field characteristics of the antenna array in an easy and efficient manner in order to determine the beam steering/forming properties.

The invention provides a wireless communication device comprising a first signal transmitting and/or receiving unit with at least one antenna element for transmitting and/or receiving a communication link signal and a separately formed phase reference unit with at least one phase reference member for receiving and/or transmitting a phase reference signal, wherein the phase reference signal and the communication link signal are phase locked in a test mode. The first signal transmitting and/or receiving unit and phase reference unit use different frequency bands, the phase reference unit is a second signal transmitting and/or receiving unit of a wireless technology different to the one of the first signal transmitting and/or receiving unit, and/or the communication link signal and the phase reference signal relate to different types of electromagnetic signal.

The invention further provides an antenna test device for testing antenna beam characteristics of a wireless communication device, comprising at least one near field measuring antenna for measuring the near field characteristics of a first signal transmitting and/or receiving unit of the wireless communication device by means of a communication link signal and a wireless phase reference interface for receiving and/or transmitting a phase reference signal from and/or to the wireless communication device, wherein the communication link signal and the phase reference signal relate to different frequency bands, different wireless technologies and/or different types of electromagnetic signal such that the communication link signal and the phase reference signal do not interfere with each other.

The invention is based on the finding that a separately formed phase reference unit can be used in order to provide a phase reference used for determining phase relationships appropriately. The phase reference is provided in an easy and effective manner such that the measurements can be performed without any greater efforts which reduce the testing time and costs significantly. The phase relationship obtained is used for transforming the near field characteristics of the radiation pattern measured by the near field measuring antenna into far field characteristics of the radiation pattern, in particular the one of the first signal transmitting and/or receiving unit. Thus, beam forming/steering properties of the first signal transmitting and/or receiving unit can be determined. Generally, the phase reference signal may be a radio frequency, intermediate frequency or clock signal which is used as the reference for the signal(s) processed by the first signal transmitting and/or receiving unit, in particular the different radio waves generating the communication link signal.

The phase lock of both signals can be selected or switched in the dedicated test mode. Thus, the phase lock can be activated and deactivated depending on the operation mode of the wireless communication device.

The different wireless technology ensures that no unwanted destructive interferences occur with regard to the communication link signal and the phase reference signal as the different wireless technologies do not interfere with each other.

The different frequency bands ensure that unwanted interferences do not occur. The frequency bands used may correspond to the frequency bands D and F. For instance, the communication link signal has a frequency in the range of 3.5 GHz whereas the phase reference signal has a frequency in the range of 1.8 GHz.

According to an aspect, the first transmitting and/or receiving unit comprises an antenna array, in particular wherein the phase reference signal is a reference for all antenna elements of the antenna array. Accordingly, the phase reference signal can be used for all antenna elements of the antenna array in order to obtain a phase relationship between the radio waves transmitted and/or received by the individual antenna elements of the antenna array. Due to the phase relationship of the radio waves, the beam steering/forming properties can be determined easily as the phase relationship ensures to determine the far field characteristics of the radiation pattern.

The resulting phase relationship obtained can be combined with a (conventional) coherent antenna measurement of the individual antenna elements of the antenna array. Particularly, the coherent antenna measurements of the antenna elements can be performed in a phaseless manner. This means that it is not necessary to measure the phase of the radio waves as the separately formed phase reference unit is used for obtaining the phase information. Therefore, the test system can be simplified appropriately.

According to another aspect, the first signal transmitting and/or receiving unit comprises at least one of a transmitter and a receiver. Thus, the first signal transmitting and/or receiving unit is configured to transmit and/or receive radio waves related to the communication link signal and, further, to process the appropriate radio waves.

According to another embodiment, the phase reference unit is a light emitting/receiving device, in particular a flash light emitting diode, an infrared light emitting diode and/or a camera sensor. Accordingly, a different type of electromagnetic signal can be used for providing the phase reference signal with regard to the communication link signal, for instance light in the visible frequency range.

According to another aspect, the at least one phase reference member of the phase reference unit is arranged perpendicular to the antenna element of the first signal transmitting and/or receiving unit or on the opposite side with respect to the antenna element of the first signal transmitting and/or receiving unit. This ensures that a maximum distance between the first signal transmitting and/or receiving unit as well as the phase reference unit is provided, in particular its phase reference member, such that unwanted interferences are minimized. Furthermore, the testing setup is simplified appropriately.

Moreover, the wireless communication device may be a base station, in particular an Evolved Node B (eNodeB). Accordingly, the wireless communication device may be established by a device that communicates with mobile handsets, also called user equipment such as mobile phones. The base station of the eNodeB type ensures inter alia high data rates.

According to another aspect, the phase reference interface is established by a light emitting/receiving device, in particular a flash light emitting diode, an infrared light emitting diode and/or a camera sensor. Thus, the phase reference interface may directly communicate with the phase reference unit of the wireless communication device that can be established by a light emitting/receiving device such as a flash light emitting diode, an infrared light emitting diode and/or a camera sensor. Generally, it is ensured that the antenna test device and the wireless communication device are enabled to exchange the phase reference signal with each other directly. This means that both devices are configured to receive and to transmit the respective phase reference signal.

Further, the invention provides a test system comprising at least one of a wireless communication device as described above and an antenna test device as described above. The test system is used to test the antenna beam characteristics of the wireless communication device. The advantages mentioned above also apply to the test system in a similar manner.

In addition, the invention provides a method for testing antenna beam characteristics of a wireless communication device, according to claim 10.

Therefore, it is possible that a phase relationship of the radio wave used for inter alia generating the communication link signal can be determined while using the separate phase reference signal. The measurements to be performed are simplified and the overall measurement time is reduced with respect to the measurement known in the state of the art as the radio wave can be measured in a phaseless manner since the phase relationship is provided by the phase reference signal separately.

The exchange of the at least one radio wave used for generating the communication link signal may correspond to a (conventional) coherent antenna measurement without any phase measurement of the individual radio wave inter alia generating the communication link signal.

According to an aspect, a phase relationship of the radio wave with respect to the phase reference signal is determined, in particular for the radio waves processed by each antenna element of an antenna array used for exchanging the communication link signal. Thus, the antenna elements of the antenna array can be measured in a conventional manner without any phase measurement which results in a simplified measurement of the antenna array being less time consuming. The antenna test device is configured to receive the separately outputted phase reference signal in order to determine the phase differences of the different radio waves received from the individual antenna elements. Alternatively, the antenna test device outputs the phase reference signal that is received by the wireless communication device.

As the several phase relationships for each individual antenna element of the antenna array are determined, the phase differences of the radio waves radiated/received by the individual antenna elements can be determined.

Moreover, the near field measured may be transformed into a far field. Thus, the antenna test device is configured to transform the near field characteristics measured by using the near field measuring antenna into a far field in order to determine the beam steering/forming properties of the antenna array. Alternatively or supplementary, a separately formed control and analyzing unit is configured to determine the far field characteristics based upon the near field characteristics determined and the phase reference signal.

According to another aspect, light emitted, light received or a signal using wireless technology different to the one of the communication link signal is used as the phase reference signal. Thus, it is ensured that no interferences between the communication link signal and the phase reference signal occur which might impair the testing of the antenna beam characteristics of the wireless communication device.

Moreover, a regular wireless communication device can be used for testing purposes wherein the light emitting/receiving unit, for instance a flash LED, is configured to act as the phase reference unit in a certain test mode.

Alternatively or supplementary, the test system and the method provides a control and analyzing unit for controlling the wireless communication device and/or the antenna test device. Further, the control and analyzing unit is configured to process the signals received, in particular the radio waves generating the communication link signal as well as the phase reference signal.

The control and analyzing unit may be formed separately with respect to the wireless communication device and/or the antenna test device.

The control and analyzing unit is also configured to transform the radiation pattern characteristics appropriately, namely the near field characteristics into far field characteristics in order to determine the beam steering/forming properties of the wireless communication device, namely the antenna beam characteristics.

The invention will now be described with reference to the accompanied drawings. In the drawings:

- Figure 1 shows a test system according to the invention comprising a wireless communication device according to the invention and an antenna test device according to the invention,

- Figure 2 shows a wireless communication device according to another embodiment of the invention,

- Figure 3 shows an antenna array used in the wireless communication device according to the invention, and

- Figure 4 shows a flow chart representing a method for testing antenna beam characteristics of a wireless communication device according to the invention.

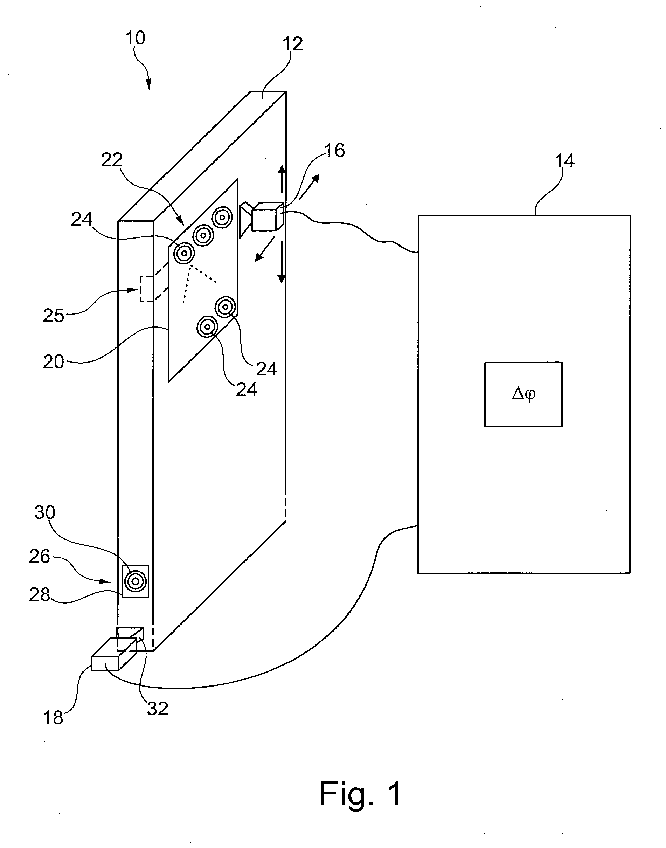

In Figure 1, a test system 10 for testing antenna beam characteristics of a wireless communication device is shown that comprises a wireless communication device 12 and an antenna test device 14.

The antenna test device 14 has at least one near field measuring antenna element 16 for measuring the near field characteristics of the wireless communication device 12. Further, the antenna test device 14 has a wireless phase reference interface 18 for receiving and/or transmitting a phase reference signal. Generally, the near field measuring antenna element 16 can be used for receiving and/or transmitting radio waves.

In the shown embodiment, the wireless communication device 12 may be established by a base station, in particular an Evolved Node B, that is used for communicating with mobile end devices such as mobile phones.

The wireless communication device 12 has a first signal transmitting and/or receiving unit 20 that is established by an antenna array 22 such that the first signal transmitting and/or receiving unit 20 comprises several antenna elements 24. The first signal transmitting and/or receiving unit 20 is connected to an internal transceiver 25. Alternatively to the transceiver 25, the wireless communication device 12 may comprise only a transmitter, only a receiver or a transmitter and a receiver separately formed.

In general, the first signal transmitting and/or receiving unit 20, in particular the several antenna elements 24, is configured to provide a communication link signal that is used to establish a communication channel between the wireless communication device 12 and another wireless communication device, for instance a mobile phone such as a smartphone.

Moreover, the wireless communication device 12 comprises a phase reference unit 26 with at least one phase reference member 28 for receiving and/or transmitting a phase reference signal as will be described later.

As shown, the phase reference unit 26 is located at a side of the wireless communication device 12 that is perpendicular to the side of the wireless communication device 12 which comprises the first signal transmitting and/or receiving unit 20. This ensures that the signals of the phase reference unit 26 and the first signal transmitting and/or receiving unit 20 do not interfere with each other which might impair the testing.

In the shown embodiment, the phase reference unit 26, in particular its phase reference member 28, is provided by a light emitting unit 30, for instance a (flash) light emitting diode (LED) or a infrared light emitting diode.

Thus, the wireless phase reference interface 18 of the antenna test device 14 communicating with the phase reference unit 26 is provided by a light receiving unit 32, for instance a camera sensor (connected to a waveguide such as an optical fiber).

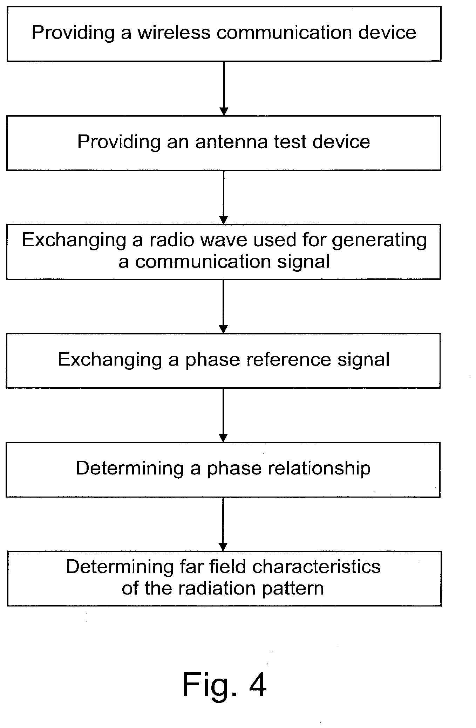

As shown in Figure 4, the testing procedure of the antenna beam characteristics of the radiation pattern comprises the step of exchanging at least one radio wave used for generating a communication link signal between the wireless communication device 12 and the antenna test device 14.

Thus, the antenna array 22, in particular one of its antenna elements 24, may radiate a radio wave used for generating a communication link signal that is received by the near field measuring antenna element 16 of the antenna test device 14. Alternatively, the near field measuring antenna element 16 radiates a radio wave received by the antenna array 22, in particular each of the individual antenna elements 24.

Simultaneously, a phase reference signal is exchanged between the wireless communication device 12 and the antenna test device 14. For instance, the phase reference unit 26 emits a light used as the phase reference signal via its phase reference member 28 that is received by the wireless phase reference interface 18 of the antenna test device 14 such that a phase relationship of the several radio waves received by the antenna array 22 is obtained. Alternatively, the antenna test device 14 transmits the phase reference signal that is received by the wireless communication device 12.

In a test mode, the phase reference signal and the communication link signal are phase locked such that the individual signals received via the antenna array 22, in particular via the individual antenna elements 24, can be put in relation with respect to each other such that the antenna test device 14 is enabled to determine any phase differences. This enables the antenna test device 14 to transform the near field characteristics measured into far field characteristics in an appropriate manner.

Alternatively or supplementary, a separately formed control and analyzing unit (not shown in Figure 1) can be provided for controlling the wireless communication device 12 and the antenna test device 14 appropriately.

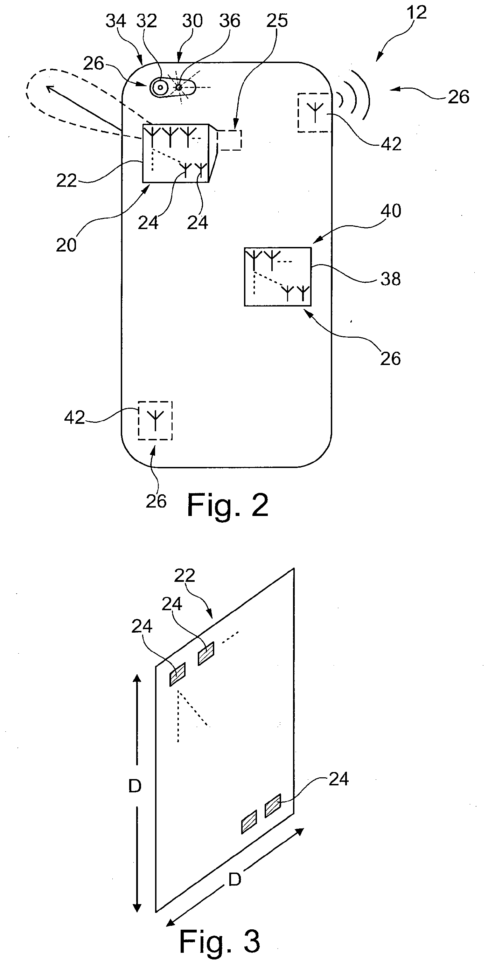

In Figure 3, the antenna array 22 of the wireless communication device 12 is schematically shown illustrating the dependency of the far field generated on the aperture $D^2$ of the antenna array 22 and the wavelength A of the signals processed. The aperture $D^2$ mainly corresponds to the (active) area of the antenna array 22 being square in the shown embodiment.

In Figure 2, another wireless communication device 12 according to the invention is shown that is established by a mobile phone, in particular a smartphone.

The wireless communication device 12 comprises besides the antenna array 22 establishing the first signal transmitting and/or receiving unit 20, a camera 32 having a camera sensor 34 and a flash light emitting diode 36 representing the light emitting unit 30. Accordingly, the camera 32 relates to a light receiving unit. The camera 32 as well as the flash light emitting diode 36 each may be used as the phase reference unit 26.

Furthermore, the wireless communication device 12 comprises a second antenna array 38 that establishes a second signal transmitting and/or receiving unit 40. This second signal transmitting and/or receiving unit 40 can be used as the phase reference unit 26.

Moreover, the wireless communication device 12 has another antenna element 42 that is used as the phase reference unit 26. The antenna element 42 may be configured to use a wireless technology being different to the one of the first signal transmitting and/or receiving unit 20 such that disturbing interferences are reduced.

Thus, the communication link signal, in particular the different radio waves generating the communication link signal, and the phase reference signal uses different frequency bands. For instance, the communication link signal uses a frequency band in the range of 3.5 GHz whereas the phase reference signal uses a frequency band in the range of 1.8 GHz. Accordingly, the frequency bands D and F may be used. Further, the different technologies may relate to Bluetooth, Global System for Mobile Communications (GSM) and/or Long Term Evolution (LTE) or any other suitable wireless technologies.

In order to reduce the interferences, the phase reference unit 26 may be located on an opposite side of the wireless communication device 12 such that the interferences are minimized appropriately. This is shown in Figure 2 as the additional antenna elements 42 are on the front side of the wireless communication device 12 (dashed lines) whereas the first signal transmitting and/or receiving unit 20 is located on the respective rear side.

In general, the test system 10 as well as the method enable the user to determine the far field characteristics of the wireless communication device 12 even though the antenna test device 14 for testing the antenna beam characteristics of the wireless communication device 12 only comprises a near field measuring antenna element 16 that measures the near field characteristics of the radiation pattern appropriately. This is enabled as a phase reference is provided even though the individual antenna elements 24 of the first signal transmitting and/or receiving unit 20 used for transmitting/receiving the communication link signal are measured by coherent antenna measurements. The additional phase information is retrieved by taking the separate phase reference signal into account.

Due to the additional phase reference unit 26 used for receiving and/or transmitting a phase reference signal, a phase relationship between the different radio waves of the individual antenna elements 24 of the antenna array 22 used for generating the communication link signal enables the antenna test device 14 to determine the far field characteristics appropriately. Thus, beam steering/forming properties of the wireless communication device 12 can be determined.

**Claims**

1. A wireless communication device (12) comprising a first signal transmitting and/or receiving unit (20) with at least one antenna element (24) for transmitting and/or receiving a communication link signal, wherein the wireless communication device (12) comprises a separately formed phase reference unit (26) with at least one phase reference member (28) for receiving and/or transmitting a phase reference signal, **characterized in that**

   the phase reference signal and the communication link signal are phase locked in a test mode, wherein
   the first signal transmitting and/or receiving unit (20) and phase reference unit (26) use different frequency bands,
   the phase reference unit (26) is a second signal transmitting and/or receiving unit (40) of a wireless technology different to the one of the first signal transmitting and/or receiving unit (20), and/or
   the communication link signal and the phase reference signal relate to different types of electromagnetic signal.

2. The wireless communication device (12) according to claim 1, wherein the first signal transmitting and/or receiving unit (20) comprises an antenna array (22), in particular wherein the phase reference signal is a reference for all antenna elements (24) of the antenna array (22).

3. The wireless communication device (12) according to claim 1 or 2, wherein the first signal transmitting and/or receiving unit (20) comprises at least one of a transmitter and a receiver.

4. The wireless communication device (12) according to any of the claims 1 to 3, wherein the phase reference unit (26) is a light emitting/receiving unit (30), in particular a flash light emitting diode (36), an infrared light emitting diode and/or a camera sensor (34).

5. The wireless communication device (12) according to any of the preceding claims, wherein the at least one phase reference member (28) of the phase reference unit (26) is arranged perpendicular to the antenna element (24) of the first signal transmitting and/or receiving unit (20) or on the opposite side with respect to the antenna element (24) of the first signal transmitting and/or receiving unit (20).

6. The wireless communication device (12) according to any of the preceding claims, wherein the wireless communication device (12) is a base station, in particular an Evolved Node B.

7. An antenna test device (14) for testing antenna beam characteristics of a wireless communication device (12), comprising at least one near field measuring antenna (16) for measuring the near field characteristics of a first signal transmitting and/or receiving unit of the wireless communication device (12) by means of a communication link signal, wherein the antenna test device (14) further comprises a wireless phase reference interface (18) for receiving and/or transmitting a phase reference signal from and/or to the wireless communication device (12), **characterized in that** the communication link signal and the phase reference signal are phase locked in a test mode and further relate to different frequency bands, different wireless technologies and/or different types of electromagnetic signal such that the communication link signal and the phase reference signal do not interfere with each other.

8. The antenna test device (14) according to claim 7, wherein the phase reference interface (18) is established by a light emitting/receiving device (32), in particular a flash light emitting diode, an infrared light emitting diode and/or a camera sensor.

9. A test system (10), comprising at least one of a wireless communication device (12) according to any of claims 1 to 6 and an antenna test device (14) according to claim 7 or 8.

10. A method for testing antenna beam characteristics of a wireless communication device (12), with the following steps:

- Exchanging at least one radio wave used for generating a communication link signal between a wireless communication device (12) according to any of claims 1 to 6 and an antenna test device (14) according to claim 7 or 8. and
- Exchanging a phase reference signal between the wireless communication device (12) and the antenna test device (14),

**characterized in that**

the communication link signal and the phase reference signal are phase locked in a test mode and further relate to different frequency bands, different wireless technologies and/or different types of electromagnetic signal such that the communication link signal and the phase reference signal do not interfere with each other.

11. The method according to claim 10, wherein a phase relationship of the radio wave with respect to the phase reference signal is determined, in particular for the radio waves processed by each antenna element (24) of an antenna array (22) used for exchanging the communication link signal.

12. The method according to claim 10 or 11, wherein the near field measured is transformed into a far field.

**Patentansprüche**

1. Drahtlose Kommunikationseinrichtung (12) mit einer ersten Signalsende- und/oder -empfangseinheit (20) mit mindestens einem Antennenelement (24) zum Senden und/oder Empfangen eines Übertragungsverbindungssignals, wobei die drahtlose Kommunikationseinrichtung (12) Folgendes umfasst

eine separat ausgebildete Phasenreferenzeinheit (26) mit mindestens einem Phasenreferenzelement (28) zum Empfangen und/oder Senden eines Phasenreferenzsignals,
**dadurch gekennzeichnet, dass**
das Phasenreferenzsignal und das Übertragungsverbindungssignal in einem Prüfmodus phasenstarr sind, wobei
die erste Signalsende- und/oder -empfangseinheit (20) und die Phasenreferenzeinheit (26) unterschiedliche Frequenzbänder verwenden,
die Phasenreferenzeinheit (26) eine zweite Signalsende- und/oder -empfangseinheit (40) mit einer anderen drahtlosen Technologie als die der ersten Signalsende- und/oder - empfangseinheit (20) ist, und/oder
sich das Übertragungsverbindungssignal und das Phasenreferenzsignal auf verschiedene Arten von elektromagnetischen Signalen beziehen.

2. Drahtlose Kommunikationseinrichtung (12) nach Anspruch 1, wobei die erste Signalsende- und/oder -empfangseinheit (20) ein Antennenarray (22) umfasst, wobei im Besonderen das Phasenreferenzsignal eine Referenz für alle Antennenelemente (24) des Antennenarrays (22) ist.

3. Drahtlose Kommunikationseinrichtung (12) nach Anspruch 1 oder 2, wobei die erste Signalsende- und/oder -empfangseinheit (20) zumindest entweder einen Sender oder einen Empfänger umfasst.

4. Drahtlose Kommunikationseinrichtung (12) nach einem der Ansprüche 1 bis 3, wobei die Phasenreferenzeinheit (26) eine Licht emittierende/empfangende Einheit (30), im Besonderen eine blinkende Leuchtdiode (36), eine Infrarot-Leuchtdiode und/oder ein Kamerasensor (34), ist.

5. Drahtlose Kommunikationseinrichtung (12) nach einem der vorstehenden Ansprüche, wobei das mindestens eine Phasenreferenzelement (28) der Phasenreferenzeinheit (26) senkrecht zu dem Antennenelement (24) der ersten Signalsende- und/oder -empfangseinheit (20) oder auf der gegenüberliegenden Seite in Bezug auf das Antennenelement (24) der ersten Signalsende- und/oder -empfangseinheit (20) angeordnet ist.

6. Drahtlose Kommunikationseinrichtung (12) nach einem der vorstehenden Ansprüche, wobei die drahtlose Kommunikationseinrichtung (12) eine Basisstation, im Besonderen ein Evolved Node B, ist.

7. Antennenprüfvorrichtung (14) zum Prüfen der Antennenstrahleigenschaften einer drahtlosen Kommunikationseinrichtung (12), umfassend mindestens eine Nahfeld-Messantenne (16) zum Messen der Nahfeldeigenschaften einer ersten Signalsende- und/oder -empfangseinheit der drahtlosen Kommunikationseinrichtung (12) mittels eines Übertragungsverbindungssignals, wobei die Antennenprüfvorrichtung (14) weiter eine drahtlose Phasenreferenzschnittstelle (18) zum Empfangen und/oder Senden eines Phasenreferenzsignals von und/oder zu der drahtlosen Kommunikationseinrichtung (12) umfasst,

**dadurch gekennzeichnet, dass**
das Übertragungsverbindungssignal und das Phasenreferenzsignal in einem Prüfmodus phasenstarr sind und sich weiter auf unterschiedliche Frequenzbänder, unterschiedliche drahtlose Technologien und/oder unterschiedliche Arten von elektromagnetischen Signalen beziehen, so dass sich das Übertragungsverbindungssignal und das Phasenreferenzsignal nicht gegenseitig stören.

8. Antennenprüfvorrichtung (14) nach Anspruch 7, wobei die Phasenreferenzschnittstelle (18) durch eine Licht emittierende/empfangende Vorrichtung (32), im Besonderen eine blinkende Leuchtdiode, eine Infrarot-Leuchtdiode und/oder einen Kamerasensor, eingerichtet wird.

9. Prüfsystem (10) umfassend zumindest entweder eine drahtlose Kommunikationseinrichtung (12) nach einem der Ansprüche 1 bis 6 oder einer Antennenprüfvorrichtung (14) nach Anspruch 7 oder 8.

10. Verfahren zum Prüfen von Antennenstrahleigenschaften einer drahtlosen Kommunikationseinrichtung (12) mit den folgenden Schritten:

    - Austauschen mindestens einer Funkwelle, die zum Erzeugen eines Übertragungsverbindungssignals zwischen einer drahtlosen Kommunikationseinrichtung (12) nach einem der Ansprüche 1 bis 6 und einer Antennenprüfvorrichtung (14) nach Anspruch 7 oder 8 verwendet wird, und
    - Austauschen eines Phasenreferenzsignals zwischen der drahtlosen Kommunikationseinrichtung (12) und der Antennenprüfvorrichtung (14),

    **dadurch gekennzeichnet, dass**
    das Übertragungsverbindungssignal und das Phasenreferenzsignal in einem Prüfmodus phasenstarr sind und sich weiter auf unterschiedliche Frequenzbänder, unterschiedliche drahtlose Technologien und/oder unterschiedliche Arten von elektromagnetischen Signalen beziehen, so dass sich das Übertragungsverbindungssignal und das Phasenreferenzsignal nicht gegenseitig stören.

11. Verfahren nach Anspruch 10, wobei eine Phasenbeziehung der Funkwelle in Bezug auf das Phasenreferenzsignal bestimmt wird, im Besonderen für die Funkwellen, die von jedem Antennenelement (24) eines Antennenarrays (22) verarbeitet werden, das zum Austauschen des Übertragungsverbindungssignals verwendet wird.

12. Verfahren nach Anspruch 10 oder 11, wobei das gemessene Nahfeld in ein Fernfeld umgewandelt wird.

**Revendications**

1. Dispositif de communication sans fil (12) comprenant une première unité de transmission et/ou réception de signal (20) dotée d'au moins un élément rayonnant (24) permettant de transmettre et/ou recevoir un signal de liaison de communication, dans lequel le dispositif de communication sans fil (12) comprend

    une unité de référence de phase (26) formée séparément, dotée d'au moins un élément de référence de phase (28) permettant de recevoir et/ou transmettre un signal de référence de phase,
    **caractérisé en ce que**
    le signal de référence de phase et le signal de liaison de communication sont verrouillés en phase dans un mode de test, dans lequel
    la première unité de transmission et/ou réception de signal (20) et l'unité de référence de phase (26) utilisent des bandes de fréquences différentes,
    l'unité de référence de phase (26) est une seconde unité de transmission et/ou réception de signal (40), d'une technologie sans fil différente de celle de la première unité de transmission et/ou réception de signal (20), et/ou
    le signal de liaison de communication et le signal de référence de phase se rapportent à des types différents de signaux électromagnétiques.

2. Dispositif de communication sans fil (12) selon la revendication 1, dans lequel la première unité de transmission et/ou réception de signal (20) comprend un réseau d'antennes (22), en particulier, dans lequel le signal de référence de phase est une référence pour tous les éléments rayonnants (24) du réseau d'antennes (22).

3. Dispositif de communication sans fil (12) selon la revendication 1 ou 2, dans lequel la première unité de transmission et/ou réception de signal (20) comprend un émetteur et/ou un récepteur.

4. Dispositif de communication sans fil (12) selon l'une quelconque des revendications 1 à 3, dans lequel l'unité de référence de phase (26) est une unité émettrice/réceptrice de lumière (30), en particulier une diode électroluminescente éclair (36), une diode électroluminescente infrarouge et/ou un capteur d'image (34).

5. Dispositif de communication sans fil (12) selon l'une quelconque des revendications précédentes, dans lequel l'au moins un élément de référence de phase (28) de l'unité de référence de phase (26) est disposé perpendiculairement à l'élément rayonnant (24) de la première unité de transmission et/ou réception de signal (20) ou du côté opposé à l'élément rayonnant (24) de la première unité de transmission et/ou réception de signal (20).

**6.** Dispositif de communication sans fil (12) selon l'une quelconque des revendications précédentes, dans lequel le dispositif de communication sans fil (12) est une station de base, en particulier un nœud B évolué.

**7.** Dispositif de test d'antenne (14) permettant de tester les caractéristiques de faisceau d'antenne d'un dispositif de communication sans fil (12), comprenant au moins une antenne de mesure en champ proche (16) permettant de mesurer les caractéristiques en champ proche d'une première unité de transmission et/ou réception de signal du dispositif de communication sans fil (12) au moyen d'un signal de liaison de communication, dans lequel le dispositif de test d'antenne (14) comprend en outre une interface de référence de phase sans fil (18) permettant de recevoir et/ou transmettre un signal de référence de phase depuis et/ou vers le dispositif de communication sans fil (12), **caractérisé en ce que** le signal de liaison de communication et le signal de référence de phase sont verrouillés en phase dans un mode de test et se rapportent en outre à des bandes de fréquences différentes, à des technologies sans fil différentes et/ou à des types différents de signaux électromagnétiques, de sorte que le signal de liaison de communication et le signal de référence de phase ne se perturbent pas l'un l'autre.

**8.** Dispositif de test d'antenne (14) selon la revendication 7, dans lequel l'interface de référence de phase (18) est établie par un dispositif émetteur/récepteur de lumière (32), en particulier une diode électroluminescente éclair, une diode électroluminescente infrarouge et/ou un capteur d'image.

**9.** Système de test (10) comprenant un dispositif de communication sans fil (12) selon l'une quelconque des revendications 1 à 6 et un dispositif de test d'antenne (14) selon la revendication 7 ou 8.

**10.** Procédé permettant de tester les caractéristiques de faisceau d'antenne d'un dispositif de communication sans fil (12), comprenant les étapes suivantes :

    - échanger au moins une onde radioélectrique utilisée pour produire un signal de liaison de communication entre un dispositif de communication sans fil (12) selon l'une quelconque des revendications 1 à 6 et un dispositif de test d'antenne (14) selon la revendication 7 ou 8, et
    - échanger un signal de référence de phase entre le dispositif de communication sans fil (12) et le dispositif de test d'antenne (14),

    **caractérisé en ce que**
le signal de liaison de communication et le signal de référence de phase sont verrouillés en phase dans un mode de test et se rapportent en outre à des bandes de fréquences différentes, à des technologies sans fil différentes et/ou à des types différents de signaux électromagnétiques, de sorte que le signal de liaison de communication et le signal de référence de phase ne se perturbent pas l'un l'autre.

**11.** Procédé selon la revendication 10, dans lequel une relation de phase de l'onde radioélectrique par rapport au signal de référence de phase est déterminée, en particulier pour les ondes radioélectriques traitées par chaque élément rayonnant (24) d'un réseau d'antennes (22) utilisé pour échanger le signal de liaison de communication.

**12.** Procédé selon la revendication 10 ou 11, dans lequel le champ proche mesuré est transformé en champ lointain.

Fig. 1

Fig. 2

Fig. 3

Providing a wireless communication device

↓

Providing an antenna test device

↓

Exchanging a radio wave used for generating
a communication signal

↓

Exchanging a phase reference signal

↓

Determining a phase relationship

↓

Determining far field characteristics
of the radiation pattern

# Fig. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **KATHREIN.** Text proposal: Near Field Measurement Method using Standard 3GPP Interfaces. *3GPP DRAFT; R4-164982, 3RD GENERATION PART-NERSHP PROJECT (3GPP), MOBILE COMPE-TENCE CENTRE; 650, ROUTE DES LUCIOLES; F-06921 SOPHIA-ANTIPOLIS CEDEX; FRANCE,* vol. RAN WG4 (Gothenburg, Sweden), 20160822-20160826